# EUROPEAN PATENT APPLICATION

(11) **EP 4 478 856 A1**
(43) Date of publication of application: **18.12.2024**
(21) Application number: 24180728.8
(22) Date of filing: 07.06.2024
(51) Int. Cl.: H10B 12/00

(54) **INTEGRATED CIRCUIT DEVICE AND METHOD OF MANUFACTURING THE SAME**

(30) Priority: 13.06.2023 KR 20230075551
(71) Applicant: Samsung Electronics Co., Ltd., Suwon-si, Gyeonggi-do 16677 (KR)
(72) Inventor: LEE, Yanghee, 16677 Suwon-si, Gyeonggi-do (KR); PARK, Jonghyuk, 16677 Suwon-si, Gyeonggi-do (KR); PARK, Hyesung, 16677 Suwon-si, Gyeonggi-do (KR); KANG, Seungji, 16677 Suwon-si, Gyeonggi-do (KR); KIM, Seongeun, 16677 Suwon-si, Gyeonggi-do (KR); LEE, Dongwon, 16677 Suwon-si, Gyeonggi-do (KR); HAN, Juyeon, 16677 Suwon-si, Gyeonggi-do (KR)
(74) Representative: Kuhnen & Wacker Patent- und Rechtsanwaltsbüro PartG mbB

(57) **Abstract**

An integrated circuit device includes a substrate having a memory cell area and a peripheral circuit area extending around the memory cell area, cell transistors in the memory cell area, and a peripheral circuit transistor in the peripheral circuit area. The device further includes: a capacitor structure including lower electrodes on the cell transistors, a dielectric layer on a surface of the lower electrodes, an upper material layer on the dielectric layer, and a metal plate layer on the upper material layer; an interlayer insulating layer on the metal plate layer in the memory cell area and on the peripheral circuit transistor in the peripheral circuit area; and an etch stop pattern in the interlayer insulating layer at a boundary portion of the memory cell area and the peripheral circuit area. The etch stop pattern is spaced laterally from a sidewall of the metal plate layer and extends vertically.

## Description

### BACKGROUND

The inventive concept relates, in general, to an integrated circuit device and a method of manufacturing the same, and more particularly, relates to an integrated circuit device including a capacitor and a method of manufacturing the integrated circuit device.

Recently, with rapid developments in a fine semiconductor processing technique, an integrated circuit device has become highly integrated at an accelerating speed so as to have a reduced unit cell area. Thus, an area which may be occupied by a capacitor in a unit cell has also been reduced. For example, in the case of an integrated circuit device, such as dynamic random-access memory (DRAM), the degree of integration increases and the unit cell area decreases, but a required capacitance is maintained or increased. Accordingly, maintaining or increasing capacitance in a structure while also maintaining desired electrical characteristics of the structure despite reduced unit cell area has been significantly challenging.

### SUMMARY

An aspect of the inventive concept provides an integrated circuit device capable of preventing ripping defects of a metal plate layer in a capacitor structure that includes an upper material layer and the metal plate layer as an upper electrode, and a method of manufacturing the integrated circuit device.

The objectives of the inventive concept are not limited to those mentioned above, and other unmentioned objectives will be clearly understood by one of ordinary skill in the art from the descriptions below.

According to an aspect of the inventive concept, there is provided an integrated circuit device including a substrate having a memory cell area and a peripheral circuit area extending around the memory cell area, a plurality of cell transistors in the memory cell area, a peripheral circuit transistor in the peripheral circuit area, a capacitor structure including lower electrodes on the plurality of cell transistors, a dielectric layer on a surface of the lower electrodes, an upper material layer on the dielectric layer, and a metal plate layer on the upper material layer, an interlayer insulating layer on the metal plate layer in the memory cell area and over the peripheral circuit transistor in the peripheral circuit area, and an etch stop pattern in the interlayer insulating layer at a boundary portion of the memory cell area and the peripheral circuit area, the etch stop pattern separated from a sidewall of the metal plate layer in a horizontal direction and extending in a vertical direction.

According to another aspect of the inventive concept, there is provided an integrated circuit device including a substrate having a memory cell area and a peripheral circuit area extending around the memory cell area, a plurality of cell transistors in the memory cell area, a peripheral circuit transistor in the peripheral circuit area, a capacitor structure including lower electrodes on the plurality of cell transistors, a dielectric layer on a surface of the lower electrodes, an upper material layer on the dielectric layer, and a metal plate layer on the upper material layer, an interlayer insulating layer over the metal plate layer in the memory cell area and over the peripheral circuit transistor in the peripheral circuit area, a first etch stop pattern in the interlayer insulating layer at a boundary portion of the memory cell area and the peripheral circuit area, the first etch stop pattern separated from a sidewall of the metal plate layer in a horizontal direction and extending in a vertical direction, and a second etch stop pattern on the interlayer insulating layer in the memory cell area, the second etch stop pattern separated from an uppermost surface of the metal plate layer in the vertical direction and extending in the horizontal direction.

According to another aspect of the inventive concept, there is provided an integrated circuit device including a substrate including a memory cell area and a peripheral circuit area on at least one side of the memory cell area, a plurality of cell transistors in the memory cell area, a peripheral circuit transistor in the peripheral circuit area, a capacitor structure including lower electrodes on the plurality of cell transistors, a dielectric layer on a surface of the lower electrodes, an upper material layer on the dielectric layer, and a metal plate layer on the upper material layer, an interlayer insulating layer over the metal plate layer in the memory cell area and over the peripheral circuit transistor in the peripheral circuit area, a vertical etch stop pattern in the interlayer insulating layer at a boundary portion of the memory cell area and the peripheral circuit area, the vertical etch stop pattern separated from a sidewall of the metal plate layer in a horizontal direction and extending in a vertical direction, a metal contact passing through the interlayer insulating layer and connected to the metal plate layer in the memory cell area, and a peripheral circuit contact passing through the interlayer insulating layer and connected to the peripheral circuit transistor in the peripheral circuit area, wherein the vertical etch stop pattern includes a material having an etch selectivity with respect to the interlayer insulating layer.

According to another aspect of the inventive concept, there is provided a method of manufacturing an integrated circuit device, the method including providing a substrate having a memory cell area and a peripheral circuit area extending around the memory cell area, forming a plurality of cell transistors in the memory cell area and forming a peripheral circuit transistor and a contact pad connected to the peripheral circuit transistor in the peripheral circuit area, sequentially forming lower electrodes on the plurality of cell transistors, a dielectric layer on a surface of the lower electrodes, and an upper material layer on the dielectric layer, conformally forming a metal plate layer over the upper material layer in the memory cell area and over the contact pad in the peripheral circuit area, forming a first interlayer insulating layer conformally covering the metal plate layer, forming an etch stop layer conformally covering the first interlayer insulating layer and including a material having an etch selectivity with respect to the first interlayer insulating layer, exposing a portion of the metal plate layer by removing a portion of the etch stop layer and a portion of the first interlayer insulating layer in the peripheral circuit area, exposing the contact pad by removing a portion of the metal plate layer in the peripheral circuit area, forming a second interlayer insulating layer conformally covering the etch stop layer and the contact pad, exposing an uppermost surface of the etch stop layer by polishing the second interlayer insulating layer, and removing a portion of the etch stop layer.

### BRIEF DESCRIPTION OF THE DRAWINGS

Embodiments will be more clearly understood from the following detailed description taken in conjunction with the accompanying drawings, wherein like reference numerals (when used) indicate corresponding elements throughout the several views, and in which:
FIG. 1 is a plan view depicting a layout diagram of an example integrated circuit device, according to an embodiment;
FIG. 2 is a plan view depicting an enlarged view of a region A1 of the example integrated circuit device shown in FIG. 1;
FIG. 3 is a cross-sectional view of the example integrated circuit device shown in FIG. 2 taken along a line B1 -B1' of FIG. 2;
FIGS. 4, 5A, and 5B are cross-sectional views of integrated circuit devices according to other embodiments;
FIG. 6 is a flowchart of an example method of manufacturing an integrated circuit device, according to an embodiment;
FIGS. 7 to 17 are cross-sectional views depicting intermediate processes illustrating an example method of manufacturing an integrated circuit device according to a process order, according to an embodiment;
FIG. 18 is a plan view depicting a layout diagram of an example integrated circuit device, according to another embodiment;
FIG. 19 is a cross-sectional view of the example integrated circuit device shown in FIG. 18 taken along a line C1-C1' of FIG. 18; and
FIG. 20 is a block diagram of an example system including an integrated circuit device according to an embodiment.

### DETAILED DESCRIPTION OF THE EMBODIMENTS

Hereinafter, embodiments of the inventive concept will be described in detail with reference to the accompanying drawings.

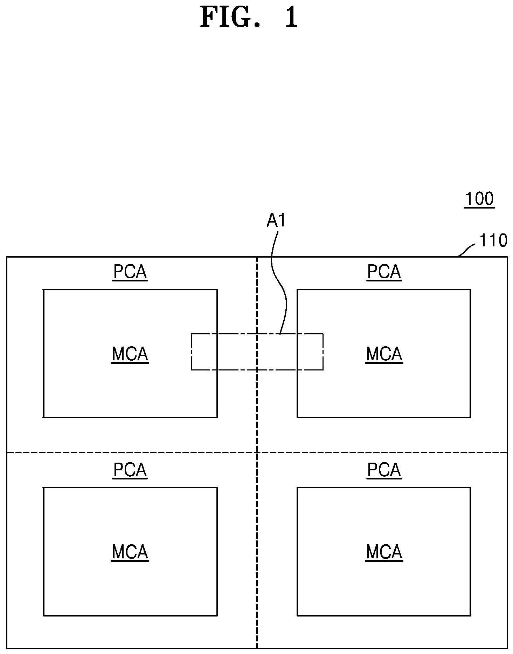

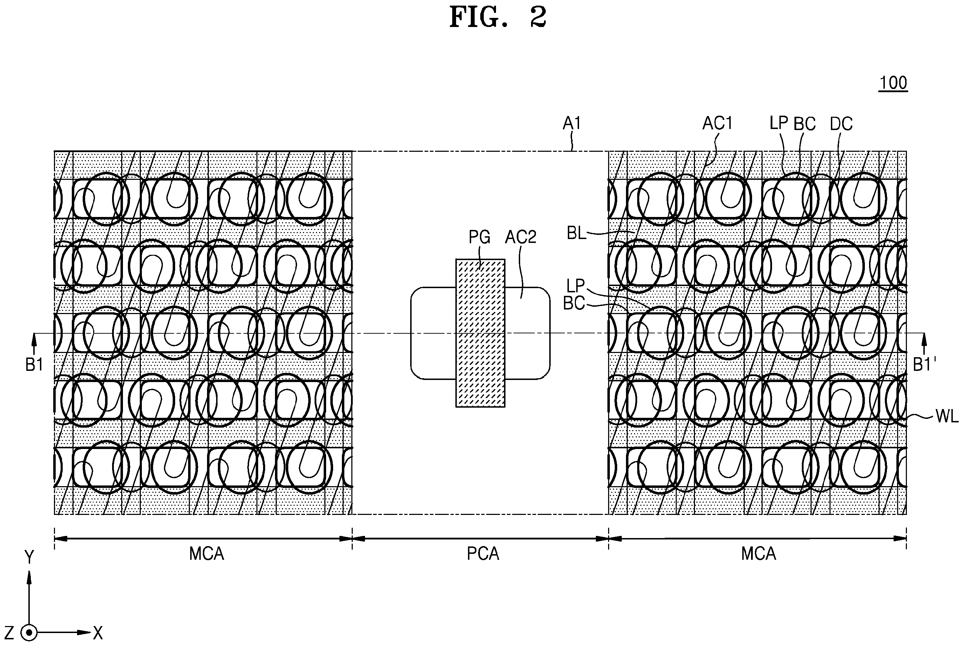

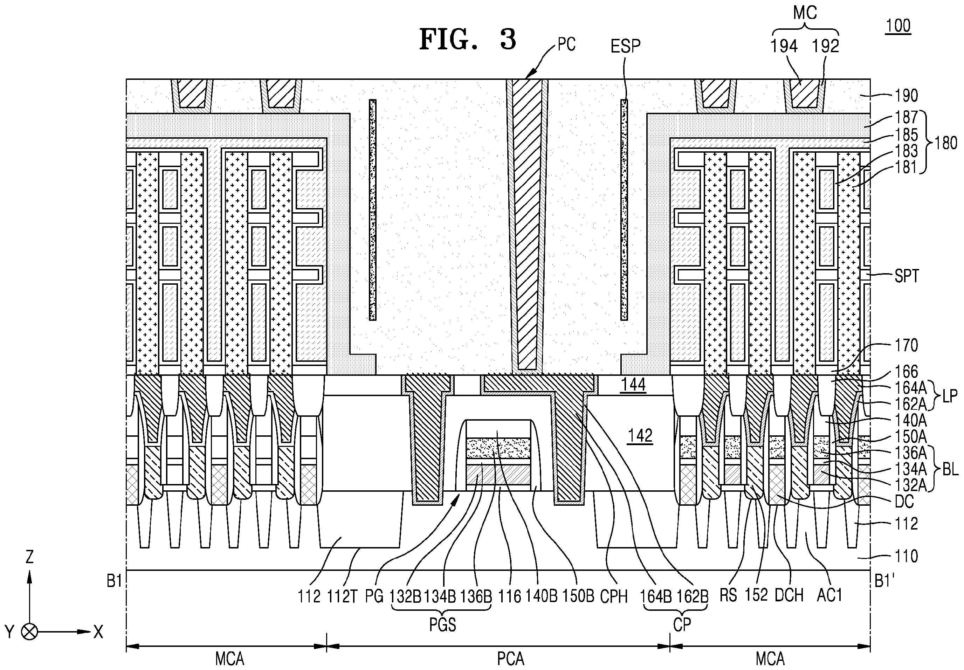

FIG. 1 is a plan view depicting a layout diagram of an example integrated circuit device 100 according to an embodiment, FIG. 2 is an enlarged view of a region A1 of the example integrated circuit device 100 shown in FIG. 1, and FIG. 3 is a cross-sectional view of the example integrated circuit device 100 taken along a line B1-B1' of FIG. 2.

Referring to FIGS. 1 to 3 together, the integrated circuit device 100 may include a substrate 110 including a memory cell area MCA and a peripheral circuit area PCA surrounding (i.e., extending around) the memory cell area MCA. The term "surrounding" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles.

The memory cell area MCA may be an area of a volatile memory cell array of dynamic random-access memory (DRAM), and the peripheral circuit area PCA may be a core area or a peripheral circuit area of the DRAM. For example, the peripheral circuit area PCA may include a peripheral circuit transistor PG configured to transmit a signal and/or a power (i.e. voltage) to a memory cell array included in the memory cell area MCA.

According to some embodiments, the peripheral circuit transistor PG may be used (alone or in conjunction with other circuit elements) to form various circuits, such as a command decoder, control logic, an address buffer, a row decoder, a column decoder, a sense amplifier, a data input/output circuit, etc.

A device isolation trench 112T may be formed in the substrate 110, and a device isolation layer 112 may be formed in (i.e., fill) the device isolation trench 112T. The term "fill" (or "filling," or like terms), as may be used herein, is intended to refer broadly to either completely filling a defined space (e.g., trench 112T) or partially filling the defined space; that is, the defined space need not be entirely filled but may, for example, be partially filled or have voids or other spaces throughout. The device isolation layer 112 may include, for example, silicon oxide, silicon nitride, or a combination thereof, although embodiments are not limited thereto. The device isolation layer 112 may define a plurality of first active areas AC1 on the substrate 110 in the memory cell area MCA and a second active area AC2 on the substrate 110 in the peripheral circuit area PCA.

Each of the plurality of first active areas AC1 may be arranged in the memory cell area MCA to have a long axis in a diagonal direction with respect to a first horizontal direction X and a second horizontal direction Y. A plurality of word lines WL may extend in parallel with each other in the first horizontal direction X across the plurality of first active areas AC1. A plurality of bit lines BL may extend in parallel with each other in the second horizontal direction Y above the plurality of word lines WL. The plurality of bit lines BL may be connected to the plurality of first active areas AC1 through a plurality of direct contacts DC.

A plurality of buried contacts BC may be formed between two adjacent bit lines BL from among the plurality of bit lines BL. The plurality of buried contacts BC may be serially arranged in the first horizontal direction X and the second horizontal direction Y. A plurality of landing pads LP may be formed above the plurality of buried contacts BC. The plurality of buried contacts BC and the plurality of landing pads LP may connect a lower electrode 181 of a capacitor structure 180 formed above the plurality of bit lines BL to the first active areas AC1. Each of the plurality of landing pads LP may be arranged such that a portion thereof overlaps the buried contact BC in a vertical direction Z. The term "overlaps" (or "overlapping," or like terms), as used herein, is intended to broadly refer to a first element that intersects with at least a portion of a second element in the vertical direction (i.e., direction Z), but does not require that the first and second elements be completely aligned with one another in a horizontal plane (i.e., in the first and second horizontal directions X, Y).

The substrate 110 may include a wafer including silicon (Si). According to some embodiments, the substrate 110 may include a wafer including a semiconductor element such as germanium (Ge) or a compound semiconductor such as silicon carbide (SiC), gallium arsenide (GaAs), indium arsenide (InAs), and indium phosphide (InP). The substrate 110 may have a silicon-on-insulator (SOI) structure. Also, the substrate 110 may include a conductive area, for example, a well doped with impurities or a structure doped with impurities.

The plurality of direct contacts DC may be formed in a plurality of direct contact holes DCH in the substrate 110. The plurality of direct contacts DC may be connected to the plurality of first active areas AC1. The plurality of direct contacts DC may include doped polysilicon, although embodiments are not limited thereto. For example, the plurality of direct contacts DC may include polysilicon including impurities, such as phosphorous (P), arsenic (As), bismuth (Bi), and antimony (Sb), in a relatively high concentration.

The plurality of bit lines BL may extend, in the second horizontal direction Y, above the substrate 110 and the plurality of direct contacts DC. Each of the plurality of bit lines BL may be connected to the first active area AC1 through the direct contact DC. Each of the plurality of bit lines BL may include a lower conductive pattern 132A, an intermediate conductive pattern 134A, and an upper conductive pattern 136A sequentially stacked on the substrate 110 in a vertical direction Z. The lower conductive pattern 132A may include doped polysilicon. Each of the intermediate conductive pattern 134A and the upper conductive pattern 136A may include, for example, titanium nitride (TiN), titanium silicon nitride (TiSiN), tungsten (W), tungsten silicide (WSi₂), or a combination thereof, although embodiments are not limited thereto. According to some embodiments, the intermediate conductive pattern 134A may include, for example, TiN, TiSiN, or a combination thereof, and the upper conductive pattern 136A may include W.

The plurality of bit lines BL may be covered by a plurality of insulating capping layers 140A. The term "covered" (or "covers" or "covering," or like terms), as may be used herein, is intended to broadly refer to a material, layer or structure being on or over another material, layer or structure, but does not require the material, layer or structure to *entirely* cover the other material, layer or structure, unless specifically stated otherwise. The plurality of insulating capping layers 140A may extend on the plurality of bit lines BL in the second horizontal direction Y. A spacer 150A may be arranged on both sidewalls of each of the plurality of bit lines BL. The spacer 150A may extend on both sidewalls of the plurality of bit lines BL in the second horizontal direction Y, and a portion of the spacer 150A may extend, in the vertical direction Z, into the direct contact hole DCH and may cover both sidewalls of the direct contact DC.

The direct contact DC may be formed in the direct contact hole DCH formed in the substrate 110 and may extend in the vertical direction Z to a level that is higher than an upper surface of the substrate 110. For example, an upper surface of the direct contact DC may be arranged on the same level as (i.e., coplanar with) an upper surface of the lower conductive pattern 132A, relative to a bottom surface of the substrate 110, and the upper surface of the direct contact DC may contact a bottom surface of the intermediate conductive pattern 134A. Also, a bottom surface of the direct contact DC may be arranged on a lower level than the upper surface of the substrate 110.

A plurality of insulating fences (not shown) and a plurality of conductive plugs 152 may be serially arranged between each of the plurality of bit lines BL in the second horizontal direction Y. The plurality of conductive plugs 152 may extend in the vertical direction Z from a recess space RS formed in the substrate 110. Both sidewalls of each of the plurality of conductive plugs 152 may be insulated from each other by the plurality of insulating fences in the second horizontal direction Y. The plurality of conductive plugs 152 may form the plurality of buried contacts BC.

The plurality of landing pads LP may be formed above the plurality of conductive plugs 152. A metal silicide layer (not shown) may further be arranged between the plurality of conductive plugs 152 and the plurality of landing pads LP. The metal silicide layer may include, for example, cobalt silicide, nickel silicide, or manganese silicide. Each of the plurality of landing pads LP may include a conductive barrier layer 162A and a landing pad conductive layer 164A. The conductive barrier layer 162A may include Ti, TiN, or a combination thereof. The landing pad conductive layer 164A may include metal, metal nitride, conductive polysilicon, or a combination thereof. The plurality of landing pads LP may have an island-type pattern shape in a plan view. The plurality of landing pads LP may be electrically insulated from each other by an insulating pattern 166 surrounding the plurality of landing pads LP.

In the peripheral circuit area PCA, the peripheral circuit transistor PG may be arranged on the second active area AC2. The peripheral circuit transistor PG may include a gate dielectric layer 116, a gate electrode PGS, and a gate capping pattern 140B sequentially stacked on the second active area AC2. The term "sequentially stacked," as may be used herein, is intended to refer broadly to an arrangement whereby a plurality of material layers, elements or structures are formed on one another in a vertical direction Z in the order specified.

The gate dielectric layer 116 may include at least one material selected from silicon oxide, silicon nitride, silicon oxynitride, and high-dielectric materials having a higher dielectric constant than silicon oxide. The gate electrode PGS may include a lower conductive pattern 132B, an intermediate conductive pattern 134B, and an upper conductive pattern 136B. Materials included in the lower conductive pattern 132B, the intermediate conductive pattern 134B, and the upper conductive pattern 136B may be the same as materials included in the lower conductive pattern 132A, the intermediate conductive pattern 134A, and the upper conductive pattern 136A included in the bit lines BL arranged in the memory cell area MCA. Also, the gate capping pattern 140B may include silicon nitride.

According to some embodiments, both sidewalls of the gate electrode PGS may be covered by a gate spacer 150B. The gate spacer 150B may include an insulating material, such as, for example, silicon oxide, silicon nitride, or a combination thereof.

The peripheral circuit transistor PG may be covered by a first insulating layer 142. A second insulating layer 144 may be arranged on the first insulating layer 142. A contact plug CP may be formed in a contact hole CPH vertically passing through (i.e., extending into) the first and second insulating layers 142 and 144 in the peripheral circuit area PCA. The contact plug CP may include a conductive barrier layer 162B and a landing pad conductive layer 164B like the plurality of landing pads LP formed in the memory cell area MCA.

An upper insulating pattern 170 may be arranged on the insulating pattern 166 in the memory cell area MCA. The upper insulating pattern 170 may include a material having an etch selectivity with respect to the second insulating layer 144 and the insulating pattern 166. For example, the upper insulating pattern 170 may include silicon nitride.

The capacitor structure 180 may be arranged on the upper insulating pattern 170 in the memory cell area MCA. The capacitor structure 180 may include a plurality of lower electrodes 181, a capacitor dielectric layer 183, a silicon germanium layer 185, and a metal plate layer 187. Here, the silicon germanium layer 185 and the metal plate layer 187 may be provided as an upper electrode of the capacitor structure 180. The silicon germanium layer 185 may be referred to as an upper material layer. However, the material included in the upper material layer is not limited to silicon germanium.

The plurality of lower electrodes 181 may extend in the vertical direction Z on the plurality of landing pads LP. A bottom portion of the plurality of lower electrodes 181 may be arranged in an opening portion of the upper insulating pattern 170. A support layer SPT may be arranged on respective sidewalls of the plurality of lower electrodes 181. Due to the support layer SPT, two adjacent lower electrodes 181 may maintain a predetermined distance between each other in the first horizontal direction X and the tilting or pulling down of the plurality of lower electrodes 181 may be prevented. The support layer SPT may be formed in plural on different levels from each other in the vertical direction Z on the sidewalls of the plurality of lower electrodes 181.

The capacitor dielectric layer 183 may be arranged on the plurality of lower electrodes 181. The capacitor dielectric layer 183 may extend in the vertical direction Z on the sidewalls of the plurality of lower electrodes 181 and onto an upper surface and a bottom surface of the support layer SPT and may extend onto the upper insulating pattern 170. The silicon germanium layer 185 may be arranged on the capacitor dielectric layer 183 to cover the plurality of lower electrodes 181.

According to some embodiments, each of the plurality of lower electrodes 181 may include, for example, at least one material selected from a metal, such as ruthenium (Ru), Ti, tantalum (Ta), niobium (Nb), iridium (Ir), molybdenum (Mo), and W, a conductive metal nitride, such as TiN, TaN, NbN, MoN, and WN, and a conductive metal oxide, such as IrO₂, RuO₂, and SrRuO₃.

According to some embodiments, the capacitor dielectric layer 183 may include at least one material from among zirconium oxide, hafnium oxide, titanium oxide, niobium oxide, tantalum oxide, yttrium oxide, strontium titanium oxide, barium strontium titanium oxide, scandium oxide, and lanthanide oxide.

The plurality of lower electrodes 181, the capacitor dielectric layer 183, and the silicon germanium layer 185 may be formed only in the memory cell area MCA. That is, the plurality of lower electrodes 181, the capacitor dielectric layer 183, and the silicon germanium layer 185 may not be formed in the peripheral circuit area PCA. Accordingly, due to a great step difference, in the vertical direction Z, between the memory cell area MCA and the peripheral circuit area PCA, a surface of the silicon germanium layer 185 may include a horizontal upper surface and a vertical side surface. That is, the silicon germanium layer 185 arranged on the plurality of lower electrodes 181 in the memory cell area MCA may have a substantially right-angled (i.e., L-shaped) surface.

The metal plate layer 187 may be arranged along the surface of the silicon germanium layer 185, the surface being shaped as such. Accordingly, a surface of the metal plate layer 187 may include a flat (i.e., horizontal) upper surface and a vertical side surface. However, a lower portion of the metal plate layer 187 may be arranged in (i.e., extend into) the peripheral circuit area PCA. According to some embodiments, the metal plate layer 187 may include W but is not limited thereto.

An interlayer insulating layer 190 may be arranged to cover both of the memory cell area MCA and the peripheral circuit area PCA. In order to cover a step difference between the memory cell area MCA and the peripheral circuit area PCA according to the presence or absence of the capacitor structure 180, the interlayer insulating layers 190 in the memory cell area MCA and the peripheral circuit area PCA may have different thicknesses in the vertical direction Z from each other; that is, a vertical level of a bottom surface of the interlayer insulating layers 190 in the memory cell area MCA and in the peripheral circuit area PCA, relative to the upper surface of the substrate 110, may be different from each other, while an upper surface of the interlayer insulating layers 190 in the memory cell area MCA and in the peripheral circuit area PCA may at the same level (i.e., coplanar), relative to the upper surface of the substrate 110.

In the integrated circuit device 100 according to the inventive concept, an etch stop pattern ESP may be arranged in the interlayer insulating layer 190 at a boundary portion of the memory cell area MCA and the peripheral circuit area PCA, more precisely, at a portion relatively more toward the peripheral circuit area PCA. According to some embodiments, the etch stop pattern ESP may be arranged to be apart from a vertical sidewall of the metal plate layer 187 in the first horizontal direction X and to extend in the vertical direction Z.

According to some embodiments, the etch stop pattern ESP may include a material having an etch selectivity with respect to the interlayer insulating layer 190. For example, the interlayer insulating layer 190 may include silicon oxide, and the etch stop pattern ESP may include at least one selected from amorphous silicon, silicon nitride, silicon oxynitride, silicon carbonitride, and silicon germanium.

According to some embodiments, a level of an uppermost surface of the etch stop pattern ESP may be higher than a level of an uppermost surface of the metal plate layer 187, relative to the upper surface of the substrate 110. Also, a level of a lowermost surface of the etch stop pattern ESP may be higher than a level of a lowermost surface of the metal plate layer 187, relative to the upper surface of the substrate 110. In addition, the level of the uppermost surface of the etch stop pattern ESP may be lower than a level of an uppermost surface of the interlayer insulating layer 190, relative to the upper surface of the substrate 110. That is, the etch stop pattern ESP may be completely surrounded by the interlayer insulating layer 190.

According to some embodiments, a sidewall of the etch stop pattern ESP may be arranged to face the vertical sidewall of the metal plate layer 187 in the first horizontal direction X. Also, the etch stop pattern ESP may be arranged to overlap a lower portion of the metal plate layer 187 in the vertical direction Z. The reason that the etch stop pattern ESP may be formed in this location is described in detail below by describing a manufacturing method.

A plurality of metal contacts MC may be arranged in the memory cell area MCA to pass through the interlayer insulating layer 190 and extend in the vertical direction Z. A bottom portion of the plurality of metal contacts MC may contact the metal plate layer 187 and may be electrically connected to the metal plate layer 187. That is, the plurality of metal contacts MC may be electrically connected to the upper electrode of the capacitor structure 180 through the metal plate layer 187. Each of the plurality of metal contacts MC may include a conductive barrier layer 192 and a contact conductive layer 194.

A peripheral circuit contact PC may be arranged in the peripheral circuit area PCA to pass through the interlayer insulating layer 190 and extend in the vertical direction Z. A bottom portion of the peripheral circuit contact PC may be connected to a contact pad, which is an upper portion of the contact plug CP. That is, the peripheral circuit contact PC may be electrically connected to the peripheral circuit transistor PG through the contact plug CP. The term "connected," as may be used herein, is broadly intended to include an electrical and/or physical connection, and may include other intervening elements unless stated otherwise. The peripheral circuit contact PC may include a conductive barrier layer 192 and a contact conductive layer 194 like the metal contact MC formed in the memory cell area MCA.

In the integrated circuit device 100 according to the inventive concept, a level of a lowermost surface of the plurality of metal contacts MC may be lower than the level of the uppermost surface of the etch stop pattern ESP, relative to the upper surface of the substrate 110. Also, a level of a lowermost surface of the peripheral circuit contact PC may be lower than the level of the lowermost surface of the etch stop pattern ESP, relative to the upper surface of the substrate 110. In addition, a vertical length of the peripheral circuit contact PC may be substantially the same as the sum of a vertical length of the metal plate layer 187 and a vertical length of the metal contact MC, with respect to the vertical direction Z.

Recently, with rapid developments in a fine semiconductor processing technique, an integrated circuit device has become highly integrated at an accelerating speed, and thus, an area of a unit cell of the integrated circuit device has been reduced. Thus, an area which may be occupied by a capacitor in the unit cell has also been reduced. For example, in the case of an integrated circuit device, such as DRAM, the degree of integration increases and the unit cell area decreases, but a required capacitance is maintained or increased. Accordingly, a structure for maintaining desired electrical characteristics by overcoming a spatial limit and limits of a design rule and improving the capacitance is needed in a capacitor.

Recently, in the integrated circuit device 100, in order to obtain a sensing margin in the capacitor structure 180, the metal plate layer 187 may be formed to cover the silicon germanium layer 185, and the silicon germanium layer 185 and the metal plate layer 187 may be used together as the upper electrode of the capacitor. In this case, ripping defects in which a corner portion of the metal plate layer 187 is also ripped may occur in a process of polishing the interlayer insulating layer 190 covering the metal plate layer 187.

In order to efficiently remove such defects, according to the inventive concept, first, a portion of the interlayer insulating layer 190 (referred to as a first interlayer insulating layer) may be formed on the metal plate layer 187 to completely cover the metal plate layer 187, and then, an etch stop layer may be formed on the first interlayer insulating layer. Next, a remaining portion of the interlayer insulating layer 190 (referred to as a second interlayer insulating layer) may be formed, and lastly, a polishing process may be performed on the second interlayer insulating layer to form the interlayer insulating layer 190 of the integrated circuit device 100. According to some embodiments, by removing a portion of the etch stop layer, the etch stop pattern ESP may be formed in the interlayer insulating layer 190. In the case of the manufacturing method described above, the first interlayer insulating layer having a sufficient cross-sectional thickness may be formed below the etch stop layer, and thus, even at a portion (for example, a corner portion) at which over-etching may occur, the metal plate layer 187 may be protected by the first interlayer insulating layer.

Ultimately, in the integrated circuit device 100 according to the inventive concept, the ripping defects of the metal plate layer 187 in the capacitor structure 180 including the silicon germanium layer 185 and the metal plate layer 187 as the upper electrode may be prevented, and thus, the defect rate may be decreased and the reliability may be increased.

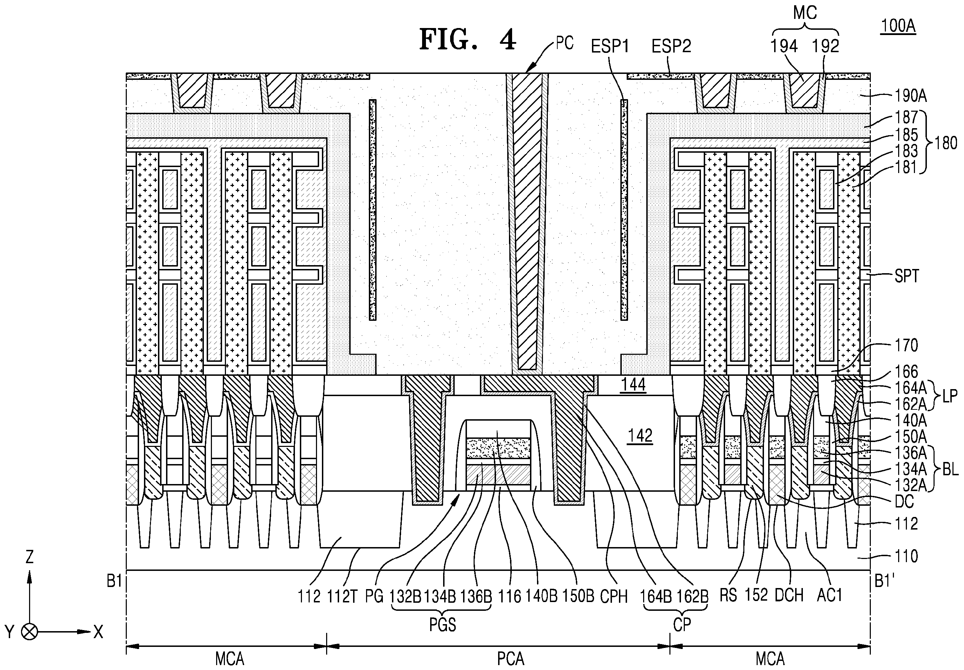

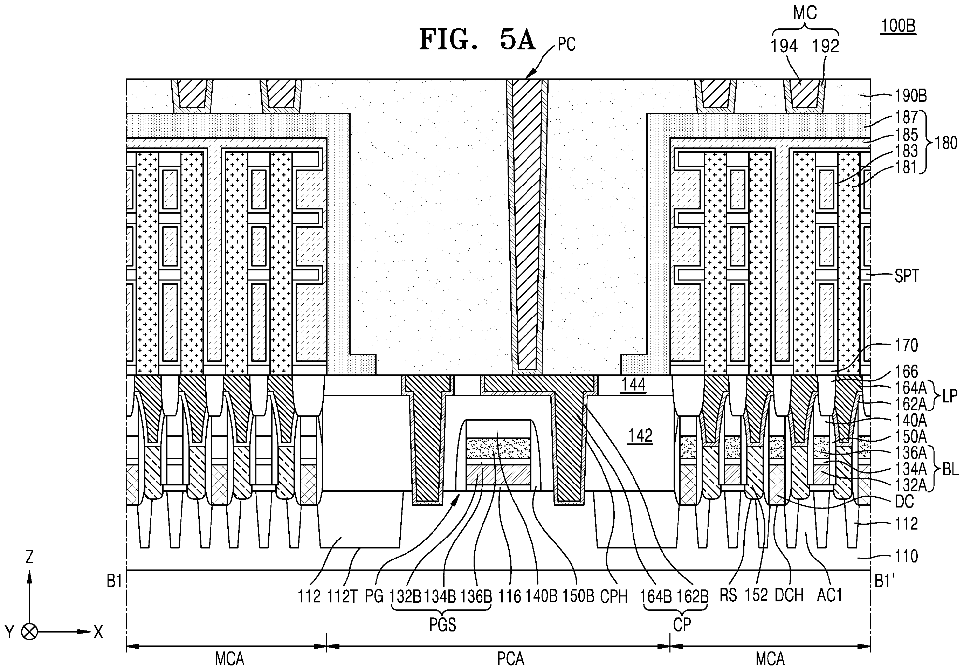

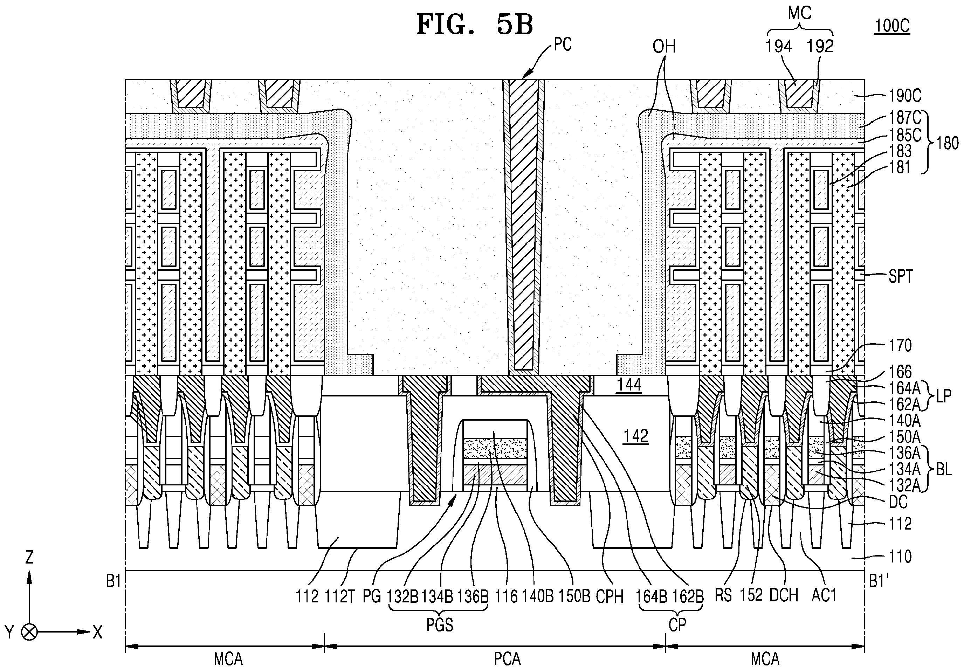

FIGS. 4, 5A, and 5B are cross-sectional views of example integrated circuit devices 100A, 100B, and 100C according to other embodiments.

Most of the elements included in the integrated circuit devices 100A, 100B, and 100C described hereinafter and materials included in the elements may be substantially the same or similar as described above with reference to FIGS. 1 to 3. Thus, for convenience of explanation, descriptions are given based on differences from the integrated circuit device 100 described above.

Referring to FIG. 4, the integrated circuit device 100A may include the substrate 110 including the memory cell area MCA and the peripheral circuit area PCA.

In the integrated circuit device 100A according to the inventive concept, a first etch stop pattern ESP1 may be arranged in an interlayer insulating layer 190A at a boundary portion of the memory cell area MCA and the peripheral circuit area PCA, more precisely, at a portion relatively more toward the peripheral circuit area PCA. According to some embodiments, the first etch stop pattern ESP1 may be arranged to be apart from a vertical sidewall of the metal plate layer 187 in a first horizontal direction X and to extend in a vertical direction Z. The first etch stop pattern ESP1 may be referred to as a vertical etch stop pattern.

In the integrated circuit device 100A according to the inventive concept, a second etch stop pattern ESP2 is arranged on the interlayer insulating layer 190A in the memory cell area MCA, spaced apart from an uppermost surface of the metal plate layer 187 in the vertical direction Z, and extending in the first horizontal direction X. According to some embodiments, the second etch stop pattern ESP2 may be arranged to be apart from a horizontal upper surface of the metal plate layer 187 in the vertical direction Z and to extend in the first horizontal direction X. The second etch stop pattern ESP2 may be referred to as a horizontal etch stop pattern.

The first etch stop pattern ESP1 and the second etch stop pattern ESP2 may be arranged on different vertical levels, relative to the upper surface of the substrate 110, to be spaced apart from each other. According to some embodiments, each of the first and second etch stop patterns ESP1 and ESP2 may include a material having an etch selectivity with respect to the interlayer insulating layer 190A. For example, the interlayer insulating layer 190A may include silicon oxide, and each of the first and second etch stop patterns ESP1 and ESP2 may include at least one selected from amorphous silicon, silicon nitride, silicon oxynitride, silicon carbonitride, and silicon germanium. Here, the first and second etch stop patterns ESP1 and ESP2 may include the same material as each other.

The plurality of metal contacts MC may be arranged in the memory cell area MCA to pass through the second etch stop pattern ESP2 and the interlayer insulating layer 190A and extend in the vertical direction Z. A bottom portion of the plurality of metal contacts MC may contact the metal plate layer 187 and may be electrically connected to the metal plate layer 187. That is, the plurality of metal contacts MC may be electrically connected to an upper electrode of the capacitor structure 180 through the metal plate layer 187. A sidewall of the plurality of metal contacts MC may contact the second etch stop pattern ESP2 and the interlayer insulating layer 190A.

The peripheral circuit contact PC may be arranged in the peripheral circuit area PCA to pass through the interlayer insulating layer 190A and extend in the vertical direction Z. A bottom portion of the peripheral circuit contact PC may be connected to a contact pad, which is a horizontal extension, in the first horizontal direction X, of an upper portion of the contact plug CP. That is, the peripheral circuit contact PC may be electrically connected to the peripheral circuit transistor PG through the contact plug CP. A sidewall of the peripheral circuit contact PC may contact the interlayer insulating layer 190A but may not contact the second etch stop pattern ESP2.

Referring to FIG. 5A, the integrated circuit device 100B may include the substrate 110 including the memory cell area MCA and the peripheral circuit area PCA.

In the integrated circuit device 100B according to the inventive concept, an interlayer insulating layer 190B may be arranged to cover both of the memory cell area MCA and the peripheral circuit area PCA. In order to cover a step difference between the memory cell area MCA and the peripheral circuit area PCA according to the presence or absence of the capacitor structure 180, the interlayer insulating layer 190B in each of the memory cell area MCA and the peripheral circuit area PCA may have a different cross-sectional thickness in the vertical direction Z from each other.

In the integrated circuit device 100B according to the inventive concept, there may be no etch stop pattern ESP (see FIG. 3). In more detail, first, a portion of the interlayer insulating layer 190B (referred to as a first interlayer insulating layer) may be formed on the metal plate layer 187 to completely cover the metal plate layer 187, and then, an etch stop layer may be formed on the first interlayer insulating layer. Next, a portion of the first interlayer insulating layer and a portion of the etch stop layer may be removed. Next, a remaining portion of the interlayer insulating layer 190B (referred to as a second interlayer insulating layer) may be formed, and lastly, a polishing process may be performed on the second interlayer insulating layer to form the interlayer insulating layer 190B of the integrated circuit device 100B. In this manner, the interlayer insulating layer 190B may have a bottom surface that is at a higher level in the memory cell area MCA than in the peripheral circuit area PCA, relative to the upper surface of the substrate 110, while an upper surface of the interlayer insulating layer 190B is substantially planar and extending in a direction parallel to the upper surface of the substrate 110 across the memory cell area MCA and the peripheral circuit area PCA. After the polishing process, the etch stop layer may be completely removed, and thus, there may be no etch stop pattern ESP (see FIG. 3) inside and outside the interlayer insulating layer 190B.

Referring to FIG. 5B, the integrated circuit device 100C may include the substrate 110 including the memory cell area MCA and the peripheral circuit area PCA.

In the integrated circuit device 100C according to the inventive concept, an interlayer insulating layer 190C may be arranged to cover both of the memory cell area MCA and the peripheral circuit area PCA. Also, like the integrated circuit device 100B (see FIG. 5A) described above, there may be no etch stop pattern ESP (see FIG. 3) in the integrated circuit device 100C.

In the integrated circuit device 100C according to the inventive concept, during a deposition process of a silicon germanium layer 185C, more deposition may be performed on a corner portion of the silicon germanium layer 185C than on other portions of the silicon germanium layer 185C. Accordingly, the corner portion of the silicon germanium layer 185C may have an overhang OH. Also, a metal plate layer 187C may be conformally formed along the silicon germanium layer 185C, and thus, a corner portion of the metal plate layer 187C may also have an overhang OH. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied.

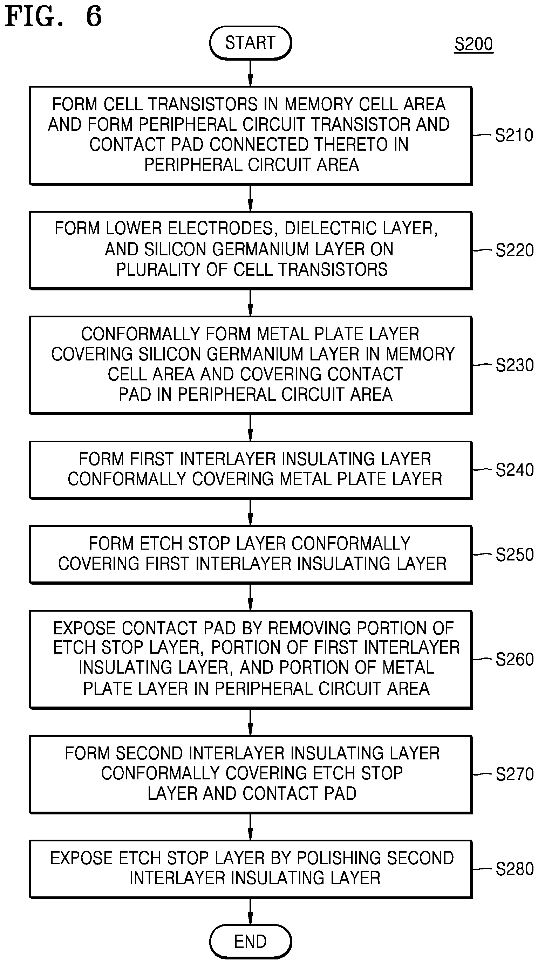

FIG. 6 is a flowchart of an example method S200 of manufacturing an integrated circuit device (e.g., any of the illustrative devices shown in FIGS. 1 - 5B), according to an embodiment of the inventive concept.

Referring to FIG. 6, the method S200 of manufacturing an integrated circuit device may include a process order of first to eighth operations S210 to S280.

When a certain embodiment is differently realized, a specific order of operations may be different from the described orders. For example, two operations sequentially described may be substantially and simultaneously performed or may be performed in orders opposite to the described orders.

With reference to FIG. 6, the method S200 of manufacturing an integrated circuit device according to the inventive concept may include: a first operation S210 of forming cell transistors in a memory cell area MCA and a peripheral circuit transistor and a contact pad connected thereto in a peripheral circuit area PCA; a second operation S220 of forming lower electrodes, a dielectric layer, and a silicon germanium layer on the plurality of cell transistors; a third operation S230 of conformally forming a metal plate layer covering the silicon germanium layer in the memory cell area and covering the contact pad in the peripheral circuit area; a fourth operation S240 of forming a first interlayer insulating layer conformally covering the metal plate layer; a fifth operation S250 of forming an etch stop layer conformally covering the first interlayer insulating layer; a sixth operation S260 of exposing the contact pad by removing a portion of the etch stop layer, a portion of the first interlayer insulating layer, and a portion of the metal plate layer in the peripheral circuit area; a seventh operation S270 of forming a second interlayer insulating layer conformally covering the etch stop layer and the contact pad; and an eighth operation S280 of exposing the etch stop layer by polishing the second interlayer insulating layer.

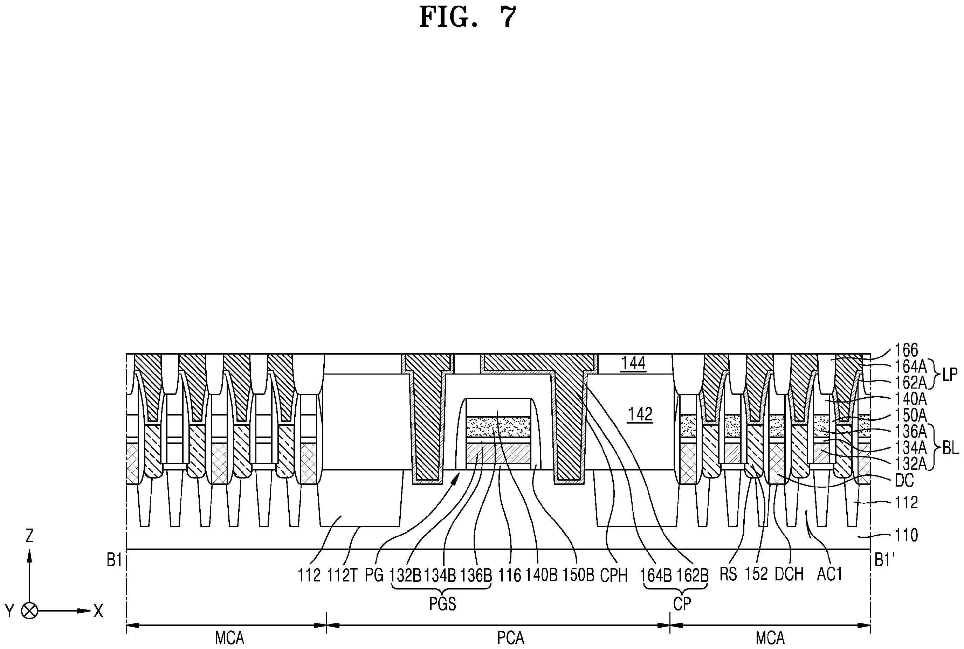

The technical characteristics with respect to each of the first to eighth operations S210 to S280 will be described in detail with reference to FIGS. 7 to 17 described below.

FIGS. 7 to 17 are cross-sectional views for illustrating intermediate processes in an example method of manufacturing an integrated circuit device according to a process order, according to an embodiment.

Referring to FIG. 7, a plurality of device isolation trenches 112T and a plurality of device isolation layers 112 at least partially filling the respective device isolation trenches 112T may be formed on the substrate 110, the substrate 110 having the memory cell area MCA and the peripheral circuit area PCA.

The plurality of device isolation layers 112 may define the plurality of first active areas AC1 on the substrate 110 in the memory cell area MCA and the second active area AC2 (see FIG. 2) on the substrate 110 in the peripheral circuit area PCA.

Next, the gate dielectric layer 116 may be formed on the substrate 110 in the peripheral circuit area PCA.

Next, by removing a portion of the substrate 110, the direct contact hole DCH exposing the first active areas AC1 may be formed, and the direct contact DC may be formed in the direct contact hole DCH.

Next, the bit lines BL and the insulating capping layer 140A may be formed on the direct contact DC, and the gate electrode PGS and the gate capping pattern 140B may be formed on the gate dielectric layer 116.

Next, the gate spacer 150B may be formed on a sidewall of the gate electrode PGS, and the first insulating layer 142 covering the gate electrode PGS may be formed.

Next, the spacer 150A may be formed on sidewalls of the bit lines BL and the insulating capping layer 140A in the memory cell area MCA, and a plurality of insulating fences (not shown) may be formed between the plurality of bit lines BL.

Next, portions of the substrate 110, the portions being arranged at bottoms of contact spaces (not shown) between the plurality of bit lines BL and between the plurality of insulating fences may be removed to form a plurality of recess spaces RS exposing the first active areas AC1 between the plurality of bit lines BL.

Next, the plurality of conductive plugs 152 filling the plurality of recess spaces RS and filling portions of the contact spaces between the plurality of bit lines BL may be formed.

Next, the plurality of contact holes CPH exposing the second active area AC2 may be formed by etching the first insulating layer 142 in the peripheral circuit area PCA.

Next, the plurality of landing pads LP including a conductive barrier layer 162A and a landing pad conductive layer 164A may be formed in the memory cell area MCA, and the plurality of contact plugs CP including a conductive barrier layer 162B and a landing pad conductive layer 164B may be formed in the peripheral circuit area PCA.

Next, the insulating pattern 166 surrounding a sidewall of the plurality of landing pads LP and the second insulating layer 144 covering a sidewall of the contact plug CP may be formed.

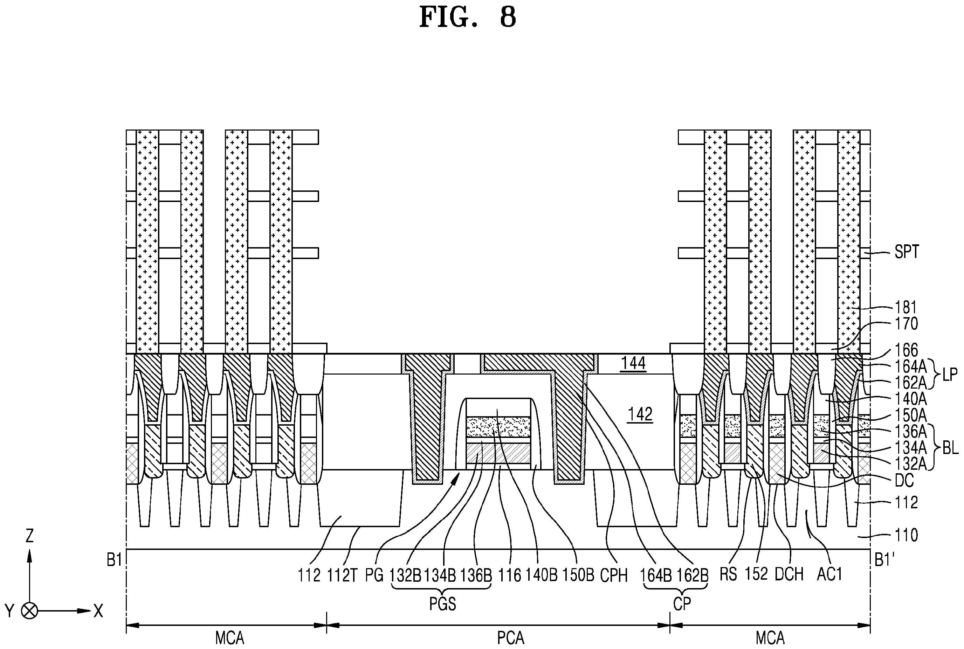

Referring to FIG. 8, in the memory cell area MCA, a mold structure including a first mold layer, a second mold layer, and a third mold layer sequentially arranged on the upper insulating pattern 170 may be formed.

Also, the support layer SPT may be selectively formed between the first mold layer and the second mold layer, between the second mold layer and the third mold layer, and on the third mold layer.

Next, a mask pattern may be formed on the mold structure, an opening passing through the mold structure may be formed by using the mask pattern as an etch mask, and the lower electrode 181 may be formed in the opening.

Next, by removing the mold structure, the upper insulating pattern 170, the lower electrode 181, and the support layer SPT may be formed.

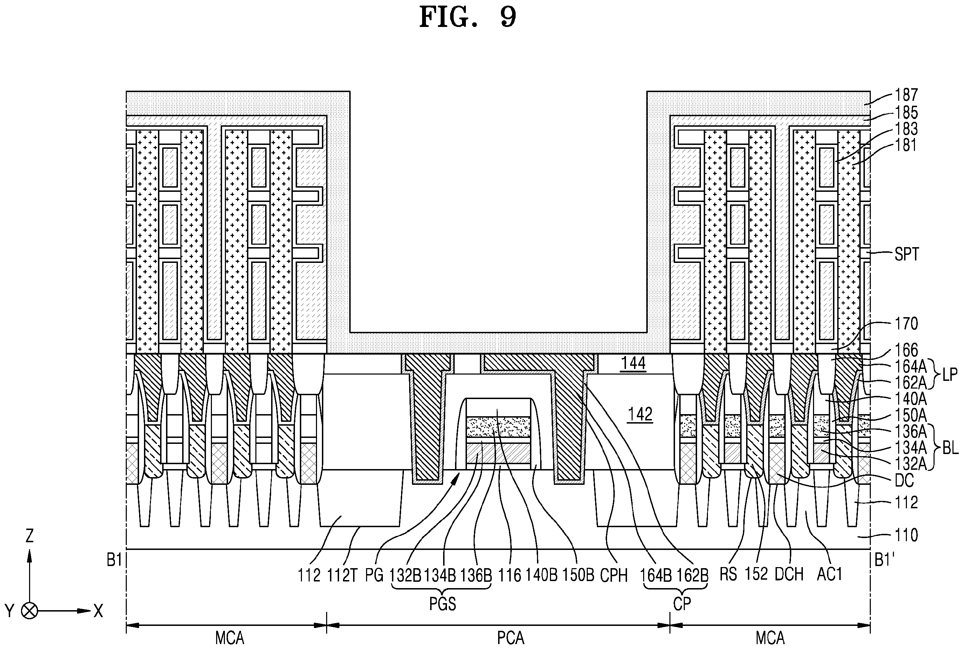

Referring to FIG. 9, the capacitor dielectric layer 183 may be formed on the upper insulating pattern 170, the lower electrode 181, and the support layer SPT, and the silicon germanium layer 185 and the metal plate layer 187 may be sequentially formed.

In detail, the metal plate layer 187 may be conformally formed to cover the silicon germanium layer 185 in the memory cell area MCA and to cover the contact pad of each of the plurality of contact plugs CP in the peripheral circuit area PCA. The metal plate layer 187 may include W but is not limited thereto.

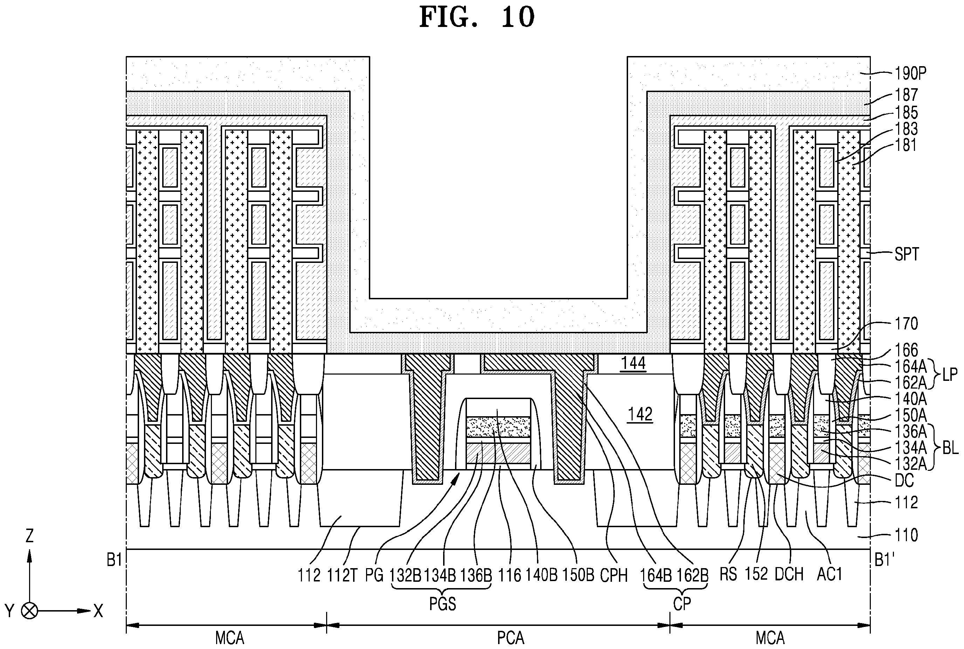

Referring to FIG. 10, a first interlayer insulating layer 190P may be formed to conformally cover the metal plate layer 187.

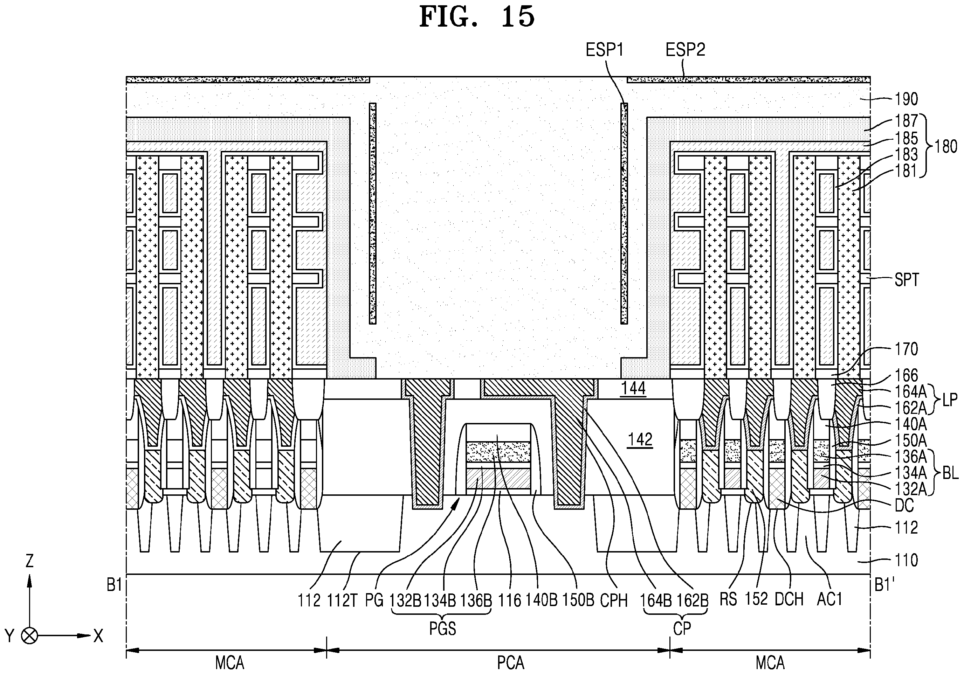

In detail, the first interlayer insulating layer 190P may be included in the interlayer insulating layer 190 (see FIG. 15) described below. The first interlayer insulating layer 190P may include silicon oxide but is not limited thereto.

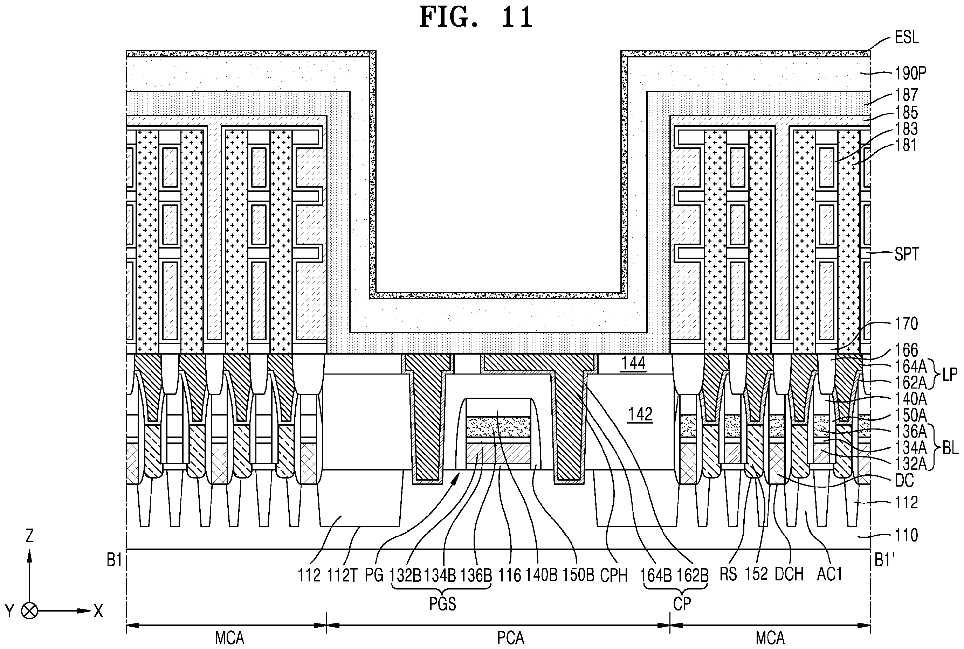

Referring to FIG. 11, an etch stop layer ESL may be formed to conformally cover the first interlayer insulating layer 190P.

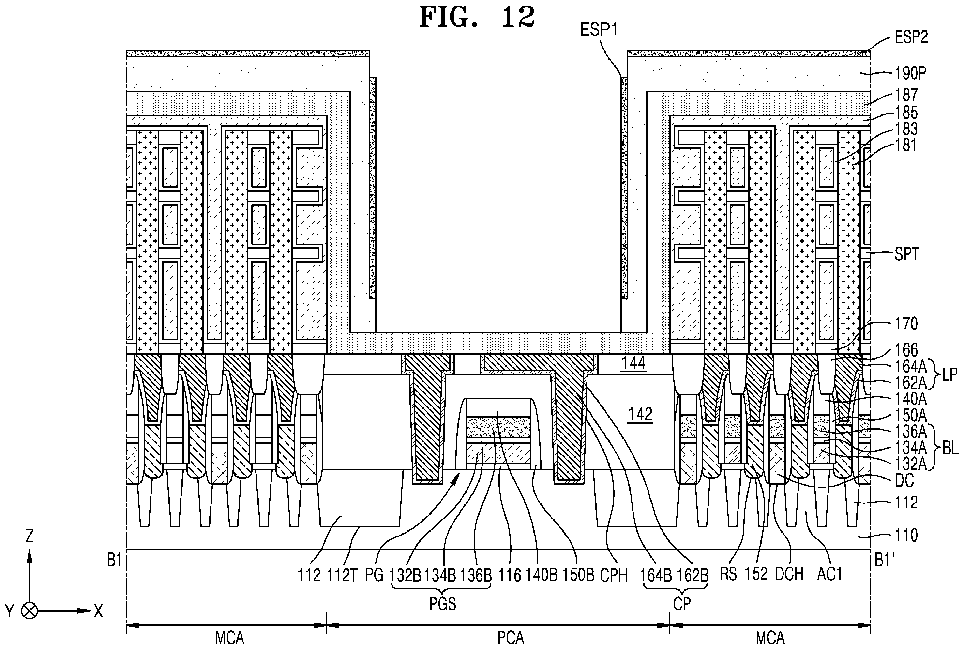

In detail, the etch stop layer ESL may be separated into the first etch stop pattern ESP1 (see FIG. 12), extending in the vertical direction Z, and the second etch stop pattern ESP2 (see FIG. 12), extending in the first horizontal direction X, described below. The etch stop layer ESL may include a material having an etch selectivity with respect to the first interlayer insulating layer 190P. The etch stop layer ESL may include at least one material selected from amorphous silicon, silicon nitride, silicon oxynitride, silicon carbonitride, and silicon germanium, but is not limited thereto.

Referring to FIG. 12, by removing a portion of the etch stop layer ESL (see FIG. 11) and a portion of the first interlayer insulating layer 190P in the peripheral circuit area PCA, a portion of the metal plate layer 187 may be exposed.

In detail, the etch stop layer ESL (see FIG. 11) may be separated into the first etch stop pattern ESP1 and the second etch stop pattern ESP2. The first etch stop pattern ESP1 may be arranged on a sidewall of the first interlayer insulating layer 190P at a boundary portion between the memory cell area MCA and the peripheral circuit area PCA, more precisely, at a portion relatively more toward the peripheral circuit area PCA. Also, in the memory cell area MCA, the second etch stop pattern ESP2 may be arranged on an upper surface of the first interlayer insulating layer 190P.

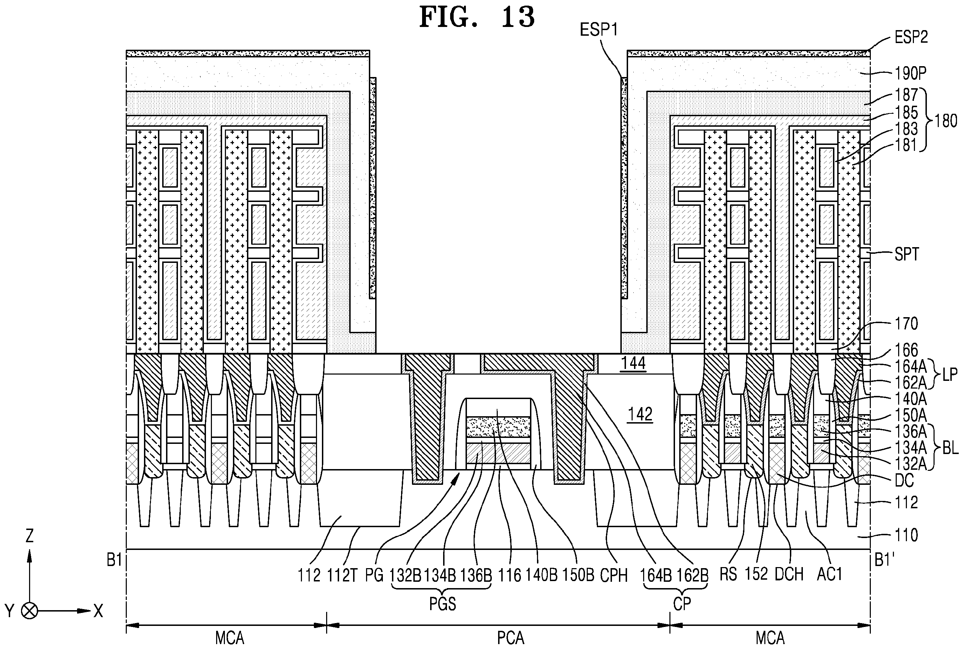

Referring to FIG. 13, in the peripheral circuit area PCA, a portion of the metal plate layer 187 may be removed to expose the contact pad of each of the plurality of contact plugs CP.

In detail, an outermost sidewall of the first etch stop pattern ESP1, an outermost sidewall of the first interlayer insulating layer 190P, and an outermost sidewall of the metal plate layer 187 may be coplanar in the vertical direction Z.

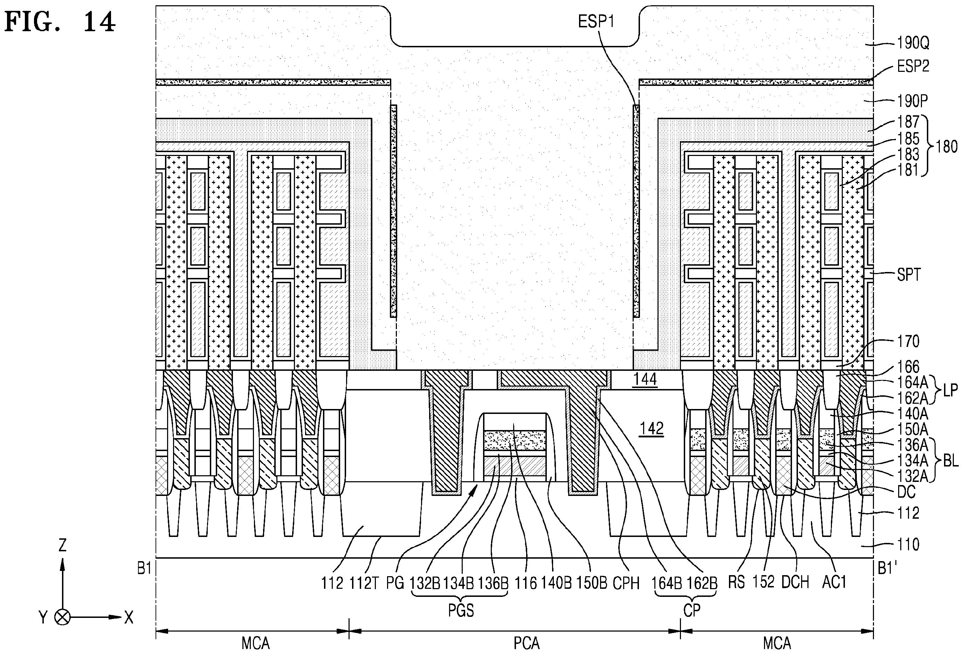

Referring to FIG. 14, a second interlayer insulating layer 190Q conformally covering the first and second etch stop patterns ESP1 and ESP2 and the contact pad of each of the plurality of contact plugs CP may be formed.

In detail, the second interlayer insulating layer 190Q may be included in the interlayer insulating layer 190 (see FIG. 15) described below. The second interlayer insulating layer 190Q may include silicon oxide like the first interlayer insulating layer 190P but is not limited thereto.

Referring to FIG. 15, the second interlayer insulating layer 190Q (see FIG. 14) may be polished by using the second etch stop pattern ESP2 as an etch stop layer.

In detail, an upper surface of the second etch stop pattern ESP2 may be exposed by polishing an upper portion of the second interlayer insulating layer 190Q (see FIG. 14). Through this polishing process, the interlayer insulating layer 190 may be formed through the first and second interlayer insulating layers 190P and 190Q (see FIG. 14).

That is, first, the first interlayer insulating layer 190P (see FIG. 10) may be formed on the metal plate layer 187, and then, the etch stop layer ESL (see FIG. 11) may be formed on the first interlayer insulating layer 190P (see FIG. 11). Thereafter, the second interlayer insulating layer 190Q (see FIG. 14) may be formed, and a polishing process may be performed on the second interlayer insulating layer 190Q (see FIG. 14) to form the interlayer insulating layer 190.

According to the inventive concept, the first interlayer insulating layer 190P (see FIG. 11) having a sufficient thickness may be formed below the etch stop layer ESL (see FIG. 11), and thus, even at a portion (for example, a corner portion) at which over-etching may occur in the polishing process of the second interlayer insulating layer 190Q (see FIG. 14), the metal plate layer 187 may be protected by the first interlayer insulating layer 190P (see FIG. 11).

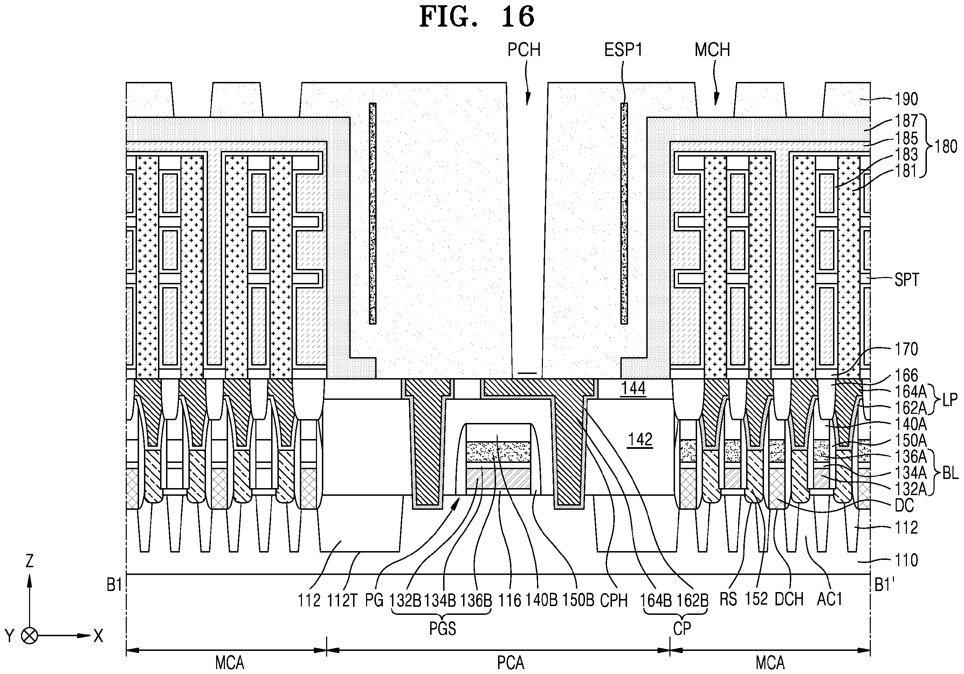

Referring to FIG. 16, the second etch stop pattern ESP2 (see FIG. 15) may be selectively removed, the plurality of metal contact holes MCH passing through the interlayer insulating layer 190 may be formed in the memory cell area MCA, and the peripheral circuit contact hole PCH passing through the interlayer insulating layer 190 may be formed in the peripheral circuit area PCA.

Here, the process in which the second etch stop pattern ESP2 (see FIG. 15) is removed is illustrated. However, according to other embodiments, the second etch stop pattern ESP2 (see FIG. 15) may not be removed.

In detail, the plurality of metal contact holes MCH formed through the interlayer insulating layer 190 may expose an uppermost surface of the metal plate layer 187, and the peripheral circuit contact hole PCH formed through the interlayer insulating layer 190 may expose an uppermost surface of the contact pad of the contact plug CP.

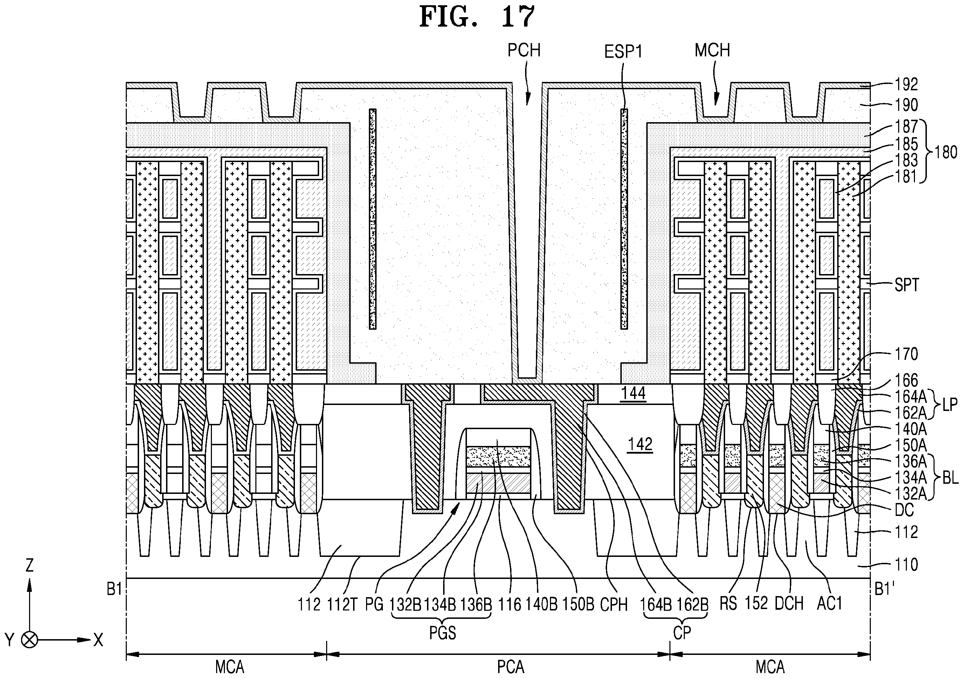

Referring to FIG. 17, the conductive barrier layer 192 conformally covering an inner sidewall of the plurality of metal contact holes MCH and the conductive barrier layer 192 conformally covering an inner sidewall of the peripheral circuit contact hole PCH may be formed.

In detail, the conductive barrier layer 192 may be continually and conformally formed throughout the memory cell area MCA and the peripheral circuit area PCA. The conductive barrier layer 192 may include Ti, TiN, or a combination thereof but is not limited thereto.

Referring to FIG. 3 again, the contact conductive layer 194 filling the plurality of metal contact holes MCH and the peripheral circuit contact hole PCH may be formed, and an upper portion of the contact conductive layer 194 and an upper portion of the conductive barrier layer 192 may be polished to form the plurality of metal contacts MC and the peripheral circuit contact PC.

According to the method of manufacturing the integrated circuit device, described above according to the inventive concept, the ripping defects of the metal plate layer 187 in the capacitor structure 180 including the silicon germanium layer 185 and the metal plate layer 187 as the upper electrode may be prevented, and thus, the defect rate may be decreased and the reliability may be increased.

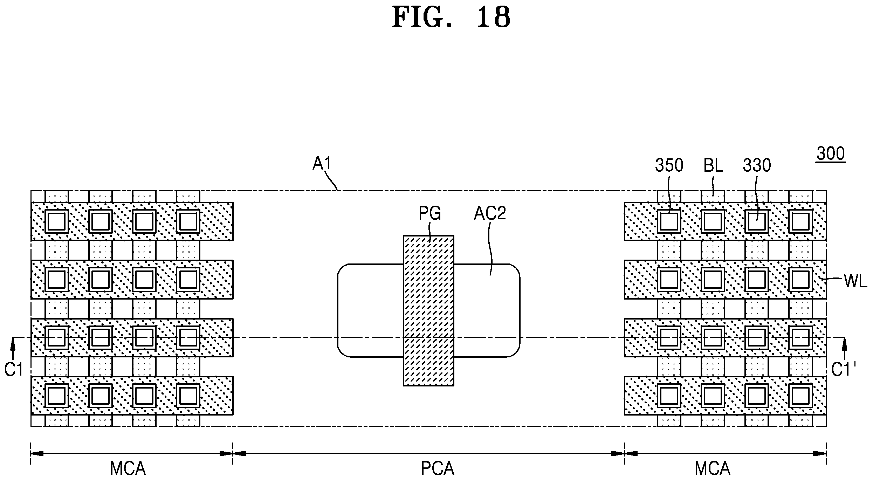

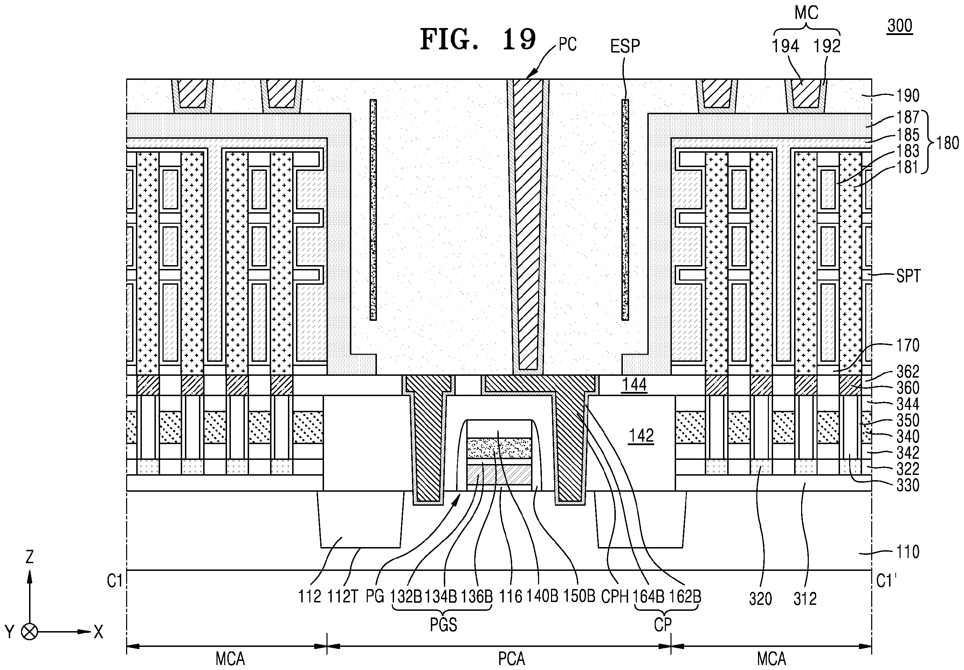

FIG. 18 is a plan view depicting a layout diagram of an example integrated circuit device 300 according to another embodiment, and FIG. 19 is a cross-sectional view of the integrated circuit device 300 shown in FIG. 18 taken along a line C1-C1' of FIG. 18.

Most of the elements included in the integrated circuit device 300 described hereinafter and materials included in the elements may be substantially the same or similar as described above with reference to FIGS. 1 to 3. Thus, for convenience of explanation, descriptions will be given based on differences from the integrated circuit device 100 described above.

Referring to FIGS. 18 and 19 together, the integrated circuit device 300 may include a plurality of first conductive lines 320, a channel layer 330, a gate electrode layer 340, a gate insulating layer 350, and the capacitor structure 180 arranged in the memory cell area MCA of the substrate 110.

The integrated circuit device 300 according to the inventive concept may be a memory device including a vertical channel transistor, and the vertical channel transistor may refer to a structure in which a channel length of the channel layer 330 extends from the substrate 110 in a vertical direction Z.

A lower insulating layer 312 may be arranged on the substrate 110, and the plurality of first conductive lines 320 may be arranged on the lower insulating layer 312 to be apart from each other in the first horizontal direction X and may extend in the second horizontal direction Y. A plurality of first insulating patterns 322 may be arranged on the lower insulating layer 312 to fill a space between the plurality of first conductive lines 320. The plurality of first conductive lines 320 may correspond to the bit lines BL of the integrated circuit device 300.

According to some embodiments, the plurality of first conductive lines 320 may include doped polysilicon, metal, conductive metal nitride, conductive metal silicide, conductive metal oxide, or a combination thereof. The plurality of first conductive lines 320 may include a single layer or multiple layers including the materials described above. According to other embodiments, the plurality of first conductive lines 320 may include a two-dimensional semiconductor material. For example, the two-dimensional semiconductor material may include graphene, a carbon nanotube, a nanosheet, or a combination thereof.

The channel layer 330 may be arranged to have an island shape arranged on the plurality of first conductive lines 320 to be apart from each other in the first horizontal direction X and the second horizontal direction Y. The channel layer 330 may have a first width in the first horizontal direction X and a first height in the vertical direction Z, relative to an upper surface of the lower insulating layer 312, wherein the first height may be greater than the first width. A bottom portion of the channel layer 330 may function as a first source/drain area (not shown), an upper portion of the channel layer 330 may function as a second source/drain area (not shown), and a portion of the channel layer 330 between the first and second source/drain areas may function as a channel area (not shown).

The gate electrode layer 340 may surround a sidewall of the channel layer 330 and extend in the first horizontal direction X. In a plan view, the gate electrode layer 340 may be a gate-all-around type surrounding all of the sidewalls (for example, the total of four sidewalls) of the channel layer 330. The gate electrode layer 340 may correspond to a word line WL of the integrated circuit device 300.

According to other embodiments, the gate electrode layer 340 may be a dual-gate type. For example, the gate electrode layer 340 may include a first sub-gate electrode (not shown) facing a first sidewall of the channel layer 330 and a second sub-gate electrode (not shown) facing a second sidewall, that is the opposite to the first sidewall, of the channel layer 330. According to other embodiments, the gate electrode layer 340 may be a single-gate type covering only the first sidewall of the channel layer 330 and extending in the first horizontal direction X.

The gate electrode layer 340 may include doped polysilicon, metal, conductive metal nitride, conductive metal silicide, conductive metal oxide, or a combination thereof, although embodiments are not limited thereto.

The gate insulating layer 350 may surround a sidewall of the channel layer 330 and may be arranged between the channel layer 330 and the gate electrode layer 340. According to some embodiments, the gate insulating layer 350 may include silicon oxide, silicon oxynitride, a high-dielectric material, or a combination thereof, although embodiments are not limited thereto.

A first buried insulating layer 342 surrounding a lower sidewall of the channel layer 330 may be arranged on the plurality of first insulating patterns 322, and a second buried insulating layer 344 surrounding an upper sidewall of the channel layer 330 and covering the gate electrode layer 340 may be arranged on the first buried insulating layer 342.

A capacitor contact 360 may be arranged on the channel layer 330. The capacitor contact 360 may be arranged to overlap the channel layer 330 in the vertical direction Z and may be arranged to have a matrix shape (i.e., islands arranged in rows and columns) in the first horizontal direction X and the second horizontal direction Y (i.e., in a plan view). An upper insulating layer 362 may surround a sidewall of the capacitor contact 360 on the second buried insulating layer 344. An upper insulating pattern 170 may be arranged on the upper insulating layer 362, and the capacitor structure 180 may be arranged on the upper insulating pattern 170.

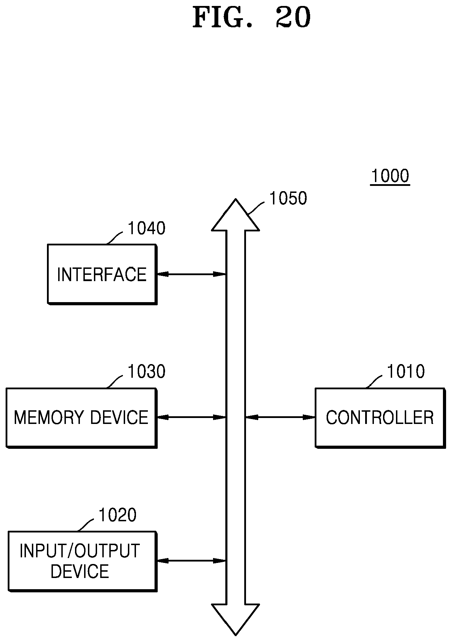

FIG. 20 is a block diagram of an example system 1000 including an integrated circuit device according to an embodiment.

Referring to FIG. 20, the system 1000 may include a controller 1010, an input/output device 1020, a memory device 1030, an interface 1040, and a bus 1050.

The system 1000 may include a mobile system or a system configured to transmit or receive information. According to some embodiments, the mobile system may include a portable computer, a web tablet, a mobile phone, a digital music player, or a memory card.

The controller 1010 may be configured to control an execution program in the system 1000 and may include a micro-processor, a digital signal processor, a micro-controller, or a device similar to the same.

The input/output device 1020 may be used to input or output data of the system 1000. The system 1000 may be connected to an external device, for example, a personal computer or a network, and may exchange data with the external device, by using the input/output device 1020. The input/output device 1020 may include, for example, a touch screen, a touch pad, a keyboard, or a display.

The memory device 1030 may store data for operations of the controller 1010 or data processed by the controller 1010. The memory device 1030 may include any one of the integrated circuit devices 100, 100A, 100B, 100C, and 300 described above according to the inventive concept.

The interface 1040 may be a data transmission path between the system 1000 and the external device. The controller 1010, the input/output device 1020, the memory device 1030, and the interface 1040 may communicate with one another through the bus 1050.

While the inventive concept has been particularly shown and described with reference to example embodiments thereof, it will be understood that various changes in form and details may be made therein without departing from the scope of the following claims.

## Claims

1. An integrated circuit device, comprising:
a substrate having a memory cell area and a peripheral circuit area extending around the memory cell area when viewed in a plan view;
a plurality of cell transistors in the memory cell area;
a peripheral circuit transistor in the peripheral circuit area;
a capacitor structure including lower electrodes on the plurality of cell transistors, a dielectric layer on a surface of the lower electrodes, an upper material layer on the dielectric layer, and a metal plate layer on the upper material layer;
an interlayer insulating layer on or over the metal plate layer in the memory cell area and on or over the peripheral circuit transistor in the peripheral circuit area; and
a first etch stop pattern in the interlayer insulating layer at a boundary portion of the memory cell area and the peripheral circuit area, the first etch stop pattern being spaced apart from a sidewall of the metal plate layer in a first direction parallel to an upper surface of the substrate and extending in a second direction perpendicular to the first direction.

2. The integrated circuit device of claim 1, wherein a first level of an uppermost surface of the first etch stop pattern is higher, relative to the upper surface of the substrate, than a second level of an uppermost surface of the metal plate layer,
a third level of a lowermost surface of the first etch stop pattern is higher, relative to the upper surface of the substrate, than a fourth level of a lowermost surface of the metal plate layer, and
the first level is lower, relative to the upper surface of the substrate, than a fifth level of an uppermost surface of the interlayer insulating layer.

3. The integrated circuit device of claim 1 or 2, wherein, in the first direction, a sidewall of the first etch stop pattern is arranged to face the sidewall of the metal plate layer, and
in the second direction, the first etch stop pattern is arranged to at least partially overlap the metal plate layer.

4. The integrated circuit device of any one of claims 1 to 3, wherein the first etch stop pattern is completely surrounded by the interlayer insulating layer in a plan view.

5. The integrated circuit device of any one of claims 1 to 4, further comprising:
a metal contact that extends through the interlayer insulating layer in the second direction and is electrically connected to the metal plate layer in the memory cell area; and
a peripheral circuit contact that extends through the interlayer insulating layer in the second direction and is electrically connected to the peripheral circuit transistor in the peripheral circuit area.

6. The integrated circuit device of claim 5, wherein a first level of a lowermost surface of the metal contact is lower, relative to the upper surface of the substrate, than a second level of an uppermost surface of the first etch stop pattern, and
a third level of a lowermost surface of the peripheral circuit contact is lower, relative to the upper surface of the substrate, than a fourth level of a lowermost surface of the first etch stop pattern.

7. The integrated circuit device of claim 5 or 6, wherein a length of the peripheral circuit contact in the second direction is greater than a length of the metal plate layer in the second direction.

8. The integrated circuit device of any one of claims 1 to 7, wherein the upper material layer and the metal plate layer are an upper electrode of the capacitor structure, the upper material layer includes a silicon germanium layer, and the metal plate layer includes tungsten.

9. The integrated circuit device of any one of claims 1 to 8, wherein the first etch stop pattern includes a material having an etch selectivity with respect to the interlayer insulating layer.

10. The integrated circuit device of claim 9, wherein the interlayer insulating layer includes silicon oxide, and
the first etch stop pattern includes at least one of amorphous silicon, silicon nitride, silicon oxynitride, silicon carbonitride, and silicon germanium.

11. The integrated circuit device of claim 1, further comprising a second etch stop pattern on the interlayer insulating layer in the memory cell area, the second etch stop pattern spaced apart from an uppermost surface of the metal plate layer in the second direction and extending in the first direction,
wherein the interlayer insulating layer is over the metal plate layer in the memory cell area and over the peripheral circuit transistor in the peripheral circuit area.

12. The integrated circuit device of claim 11, wherein the first etch stop pattern and the second etch stop pattern are spaced apart from each other in the second direction,
in the first direction, a sidewall of the first etch stop pattern faces the sidewall of the metal plate layer, and
in the second direction, a lower surface of the second etch stop pattern faces the uppermost surface of the metal plate layer.

13. The integrated circuit device of claim 11 or 12, further comprising:
a metal contact that extends through the second etch stop pattern and the interlayer insulating layer in the second direction and is electrically connected to the metal plate layer in the memory cell area; and
a peripheral circuit contact that extends through the interlayer insulating layer in the second direction and is electrically connected to the peripheral circuit transistor in the peripheral circuit area.

14. The integrated circuit device of claim 13, wherein a sidewall of the metal contact contacts the second etch stop pattern and the interlayer insulating layer, and,
a sidewall of the peripheral circuit contact contacts the interlayer insulating layer, and the sidewall of the peripheral circuit contact does not contact the second etch stop pattern.

15. The integrated circuit device of any one of claims 11 to 14, wherein the interlayer insulating layer includes silicon oxide, and
the first and second etch stop patterns include a same material as each other, and
each of the first and second etch stop patterns includes at least one of amorphous silicon, silicon nitride, silicon oxynitride, silicon carbonitride, and silicon germanium.
